# EUROPÄISCHE PATENTSCHRIFT

(11) **EP 2 710 864 B1**
(45) Veröffentlichungstag und Bekanntmachung des Hinweises auf die Patenterteilung: **27.02.2019**
(21) Anmeldenummer: 12726353.1
(22) Anmeldetag: 16.05.2012
(51) Int. Cl.: H05K 3/00, H05K 3/40, H05K 1/11, H05K 3/44

(54) **SCHALTUNGSTRÄGER**
CIRCUIT CARRIER
SUPPORT DE CIRCUIT

(30) Priorität: 17.05.2011 DE 102011101805
(43) Veröffentlichungstag der Anmeldung: 26.03.2014
(73) Patentinhaber: Fela Holding GmbH, 78054 Villingen-Schwenningen (DE)
(72) Erfinder: KRÜTT, Norbert, 78083 Dauchingen (DE); HEISER, Eberhard, 78083 Dauchingen (DE)
(74) Vertreter: Westphal, Mussgnug & Partner Patentanwälte mbB
(86) Internationale Anmeldenummer: PCT/EP2012/002111
(87) Internationale Veröffentlichungsnummer: WO 2012/156087

(56) Entgegenhaltungen:
- EP-A2- 2 037 723
- DE-A1- 3 206 354
- NL-A- 7 012 969
- US-A- 3 334 395

## Beschreibung

Die Erfindung betrifft einen LED-Schaltungsträger mit wenigstens zwei übereinander angeordneten, durch ein isolierendes Kernsubstrat getrennte Metallschichten sowie mit wenigstens auf einer der Metallschichten angeordneten Außenschicht mit Leitbahnen zur Bestückung von LEDs und vorzugsweise weiterer elektronischer Bauelemente gemäß Oberbegriff des Patentanspruchs 1 sowie ein Verfahren zur Herstellung eines erfindungsgemäßen Schaltungsträgers.

Aus der DE 10 2008 021 014 A1 ist ein solcher Schaltungsträger bekannt, welcher aus einem Mehrlagenverbund für eine Strom- und/oder Signalversorgung mit einer mehrschichtigen Leiterplatte aus zwei zueinander parallelen Schichten von Leichtmetallplatten aus Aluminium oder Aluminiumlegierungen besteht, wobei die beiden Leichtmetallplatten von einer PolyethylenSchicht getrennt werden und deren äußeren Flächen jeweils von einer weiteren Polymerschicht als Decklage bedeckt werden. Auf der freien Oberfläche dieser Decklage sind leitfähige Schichtbahnen zum Anschluss von Bauteilen wie Leuchtdioden vorgesehen, welche durch Leitungen mit den stromführenden Leichtmetallplatten verbunden sind.

Gemäß dieser DE 10 2008 021 014 A1 werden in diese mehrlagige Leiterplatte sacklochartige Ausnehmungen zur Aufnahme von Diodenkörpern von Leuchtdioden, bspw. RGB-LED's eingebracht. Diese Diodenkörper sind ebenso mehrschichtig mit stromführenden Aluminiumschichten und isolierend trennenden Polymerschichten aufgebaut, so dass diese Schichten nach dem Einführen des Diodenkörpers in eine dafür vorgesehen Ausnahme mit den Leichtmetallschichten und den Polymerschichten der Leiterplatte fluchten.

Nachteilig an einem solchen aus der DE 10 2008 021 014 A1 bekannte Schaltungsträger ist die technologisch aufwendige Herstellung des Diodenkörpers, da dieser in gleicher Weise wie die Leiterplatte mehrschichtig mit gleichen Schichtdicken aufgebaut werden muss.

Aus der EP 2 037 723 A2 ist eine Art der LED-Kontaktierung bekannt, bei der LED-Module auf einer Basisplatte mit einer ersten leitfähigen Schicht mit einer ersten Öffnung und einer zweiten leitfähigen Schicht mit einer zweiten Öffnung und einer Isolierschicht zwischen der ersten und der zweiten leitfähigen Schicht angeordnet werden und mit Befestigungselementen durch die erste beziehungsweise zweite Öffnung für die Basisplatte eingefügt werden, dass das erste Befestigungselement nur an die zweite leitfähige Schicht beziehungsweise das zweite Befestigungselement nur an die erste leitfähige Schicht elektrisch anschließbar ist.

Aus der US 3 334 395 ist eine elektrisch leitend durchkontaktierte Leiterplatte mit einem von dieser Durchkontaktierung isolierten Metallkern bekannt.

Aufgabe der Erfindung ist daher, einen Schaltungsträger der eingangs genannten Art derart fortzubilden, dass ein einfach herzustellender kompakter Aufbau erzielt wird, insbesondere hinsichtlich der für die Stromversorgung der auf dem Schaltungsträger angeordneten elektronischen Bauelementen, wie bspw. Leuchtdioden (LED) vorgesehenen Leitbahnen.

Diese Aufgabe wird gelöst durch einen Schaltungsträger mit den Merkmalen des Patentanspruchs 1.

Ein solcher Schaltungsträger zeichnet sich erfindungsgemäß dadurch aus, dass das Kernsubstrat mit einem Metallkern ausgebildet ist, welcher auf den Außenseiten, die den Metallschichten benachbart sind, eine Isolierschicht aufweist, und die Leitbahnen auf der Außenschicht über Durchkontaktierungen mit den Metallschichten elektrisch verbunden sind, wobei zur elektrischen Isolation der Durchkontaktierungen gegenüber dem Metallkern die Durchkontaktierungen mittels einer inselförmigen Isolatorschicht des Metallkerns isoliert sind.

Bei diesem erfindungsgemäßen Schaltungsträger dienen die Metallschichten als Stromschienen für die auf der Außenschicht angeordneten elektronischen Bauelemente, insbesondere von LED's, die mit diesen Metallschichten über Durchkontaktierungen kontaktiert werden, wodurch insgesamt ein kompakter Aufbau erzielt wird und gleichzeitig eine ausreichende Wärmeabfuhr über den Metallkern des Kernsubstrats sichergestellt ist.

In einer vorteilhaften Ausgestaltung der Erfindung ist es vorgesehen, die Durchkontaktierung zur auf der Außenschicht abgewandten Seite des Kernsubstrats liegenden Metallschicht als Durchgangsbohrung auszubilden, die eine elektrisch leitfähige Hülse, eine sogenannte Durchkontaktierungs-Hülse aufnimmt. Damit lassen sich über eine solche Durchgangsbohrung direkt elektronische Bauteile, insbesondere LED's mit dieser Hülse, vorzugsweise aus Kupfer kontaktieren. Dabei ist vorzugsweise die inselförmige Isolatorschicht ringförmig ausgebildet, die die Durchkontaktierungs-Hülse somit gegenüber dem Metallkern isolierend umgibt. Ferner ist weiterbildungsgemäß vorgesehen, dass die der Außenschicht zugewandte Metallschicht im Bereich der Durchkontaktierung zur Bildung eines Isolationsabstandes einen Ausschnitt aufweist, um damit einen Kurzschluss über die Durchkontaktierungs-Hülse zwischen den beiden Metallschichten zu vermeiden.

Erfindungsgemäß ist die Durchkontaktierung zur auf der Außenschicht zugewandten Seite des Kernsubstrats liegenden Metallschicht als Sacklochbohrung ausgebildet, die im Bereich dieser Metallschicht endet. Dabei kann die Durchkontaktierung in einer Weiterbildung eine elektrisch leitfähige Hülse, eine sogenannte Durchkontaktierungs-Hülse aus Kupfer aufnehmen. Erfindungsgemäß reicht hierbei der Sacklochgrund der Sacklochbohrung bis in den Bereich des Metallkerns. Um eine entsprechende Isolierung dieser Hülse gegenüber dem Metallkern sicherzustellen, umschließt erfindungsgemäß die inselförmige Isolatorschicht wenigstens bereichsweise den Sacklochgrund.

In einer anderen Ausgestaltung der Erfindung ist die Außenschicht als Leiterplatte, vorzugsweise als Mehrlagen- Leiterplatte mit wenigstens einer weiteren Leitbahnebene ausgebildet. Damit kann für die auf einer solchen Leiterplatte anzuordnenden elektronischen Bauelemente eine kompaktere Anordnung erreicht werden.

Bei einer Mehrlagen-Leiterplatte ist es weiterbildungsgemäß vorgesehen, im Bereich der Durchkontaktierung die weitere Leitbahnebene der Mehrlagen-Leiterplatte zur Bildung eines Isolationsabstandes mit einem Ausschnitt zu versehen.

Zur Herstellung der inselförmigen Isolatorschicht des erfindungsgemäßen Schaltungsträgers ist es vorgesehen, zunächst eine Bohrung, also entweder eine Durchgangsbohrung oder eine Sacklochbohrung mit gegenüber dem Durchmesser der Durchkontaktierungs-Hülsen größeren Durchmesser in den Metallkern einzubringen und mit einem Isolationsmaterial zu verfüllen und anschließend die Durchgangsbohrung bzw. die Sacklochbohrung mit einem der Durchkontaktierungs-Hülse entsprechenden Durchmesser in diesem Isolationsmaterial zu erzeugen, so dass kein Kontakt mit dem Metall des Metallkerns entsteht. Nach dem Einbringen der Durchgangbohrung bzw. der Sacklochbohrung in das Isolationsmaterial wird die Durchkontaktierungs-Hülse in die Durchgangbohrung bzw. die Sacklochbohrung eingeführt.

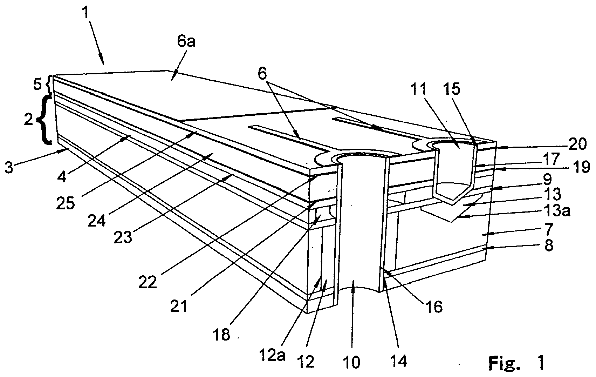

Die Erfindung wird nachfolgend anhand eines Ausführungsbeispiels unter Bezugnahme auf die einzige beigefügte Figur ausführlich beschrieben. Diese Figur 1 zeigt eine schematische perspektivische Teildarstellung mit einem Teilschnitt eines Ausführungsbeispiels eines erfindungsgemäßen Schaltungsträgers.

Der Schaltungsträger 1 gemäß Figur 1, der mit elektronischen Bauelementen, insbesondere mit Leuchtdioden (LED) auf einer mit einer Kupferschicht 6a kaschierten Oberfläche bestückt wird, weist einen mehrschichtigen Aufbau mit integrierten, als Metallschichten 3 und 4 ausgebildeten Stromschienen auf, über die die Energieversorgung dieser Leuchtdioden (nicht dargestellt) erfolgt. Die elektrische Kontaktierung mit diesen Metallschichten 3 und 4 erfolgt über Durchkontaktierungen 10 und 11.

Im Folgenden wird der Schichtenaufbau des Schaltungsträgers 1 im Detail beschrieben.

Die beiden Metallschichten 3 und 4 des Schaltungsträgers 1 werden von einem Kernsubstrat 2 getrennt, indem ein plattenförmiger Metallkern 7 aus Aluminium mit einer Dicke von ca. 1 mm auf seiner Unter- und Oberseite mit jeweils einer Isolierschicht 8 und 9 belegt ist, die jeweils als Prepreg-Schicht hergestellt werden bzw. ausgebildet sind.

An die Metallschicht 4 schließt sich eine Mehrlagen-Leiterplatte 5 mit einer kupferkaschierten freien Oberfläche an, die mit elektronischen Bauelementen, vorzugsweise mit LED's und/oder einer integrierten Schaltung bestückt wird. Diese bereits genannte Kupferschicht 6a wird in bekannter Weise zur Erzeugung von Leitbahnen 6 (andeutungsweise dargestellt) strukturiert. Diese Mehrlagen-Leiterplatte 5 umfasst zwei weitere Leitbahnebenen 19 und 20, die von einer Innenlage 24 getrennt werden und jeweils von einer Außenschicht 23 und 25 abgedeckt werden. Die Außenschicht 25 ist mit der Kupferschicht 6a kaschiert.

Diese Schichten 23, 24 und 25 werden ebenso als Prepreg-Schichten hergestellt.

Zur Herstellung der Durchkontaktierungen 10 von den Leitbahnen 6 zur Metallschicht 3 wird vor Herstellung des gesamten Schichtenaufbaus des Schaltungsträgers 1 in dem Metallkern 7 eine Durchgangsbohrung 12a erzeugt, die in dem für die Durchkontaktierung 10 vorgesehenen Bereich liegt. Diese Bohrung 12a wird mit einem Isolationsmaterial zur Bildung einer inselförmigen Isolatorschicht 12 verfüllt, die nach Einbringung einer eine Durchkontaktierungs-Hülse 16 aufnehmende Bohrung 14 nach der Herstellung des vervollständigten Schichtenaufbaus des Schaltungsträgers 1 einen ausreichenden Isolationsabstand zum Metall des Metallkerns sichern muss. Daher ist der Durchmesser der Bohrung 12a größer als die die Durchkontaktierungs-Hülse 16 aufnehmende Durchgangsbohrung 14. Die Durchkontaktierungs-Hülse 16 wird von der inselförmigen Isolatorschicht 12 ringförmig umschlossen.

Mit der Herstellung der Durchkontaktierung 10 wird auch gleichzeitig die Durchkontaktierung 11 zur Metallschicht 4 hergestellt. Hierzu wird in entsprechender Weise eine inselförmige Isolatorschicht 13 in dem Metallkern 7 im Bereich dieser Durchkontaktierung 11 erzeugt. Da diese Durchkontaktierung 11 die Form eines Sackloches 15 mit einem kegelförmigen Sacklochgrund aufweist, wobei dieses Sackloch 15 bis zur Metallschicht 4 reicht und der Sacklochgrund nur teilweise mit dessen Spitze in den Metallkern 7 eintaucht, wird in diesem Bereich des Metallkerns 7 zunächst eine kegelförmige Bohrung 13a erzeugt, deren laterale Ausdehnung so groß ist, dass der Sacklochgrund der Sacklochbohrung 15 einen ausreichenden Isolationsabstand zum Metall des Metallkerns 7 aufweist. Diese Bohrung 13a wird anschließend mit Isolationsmaterial verfüllt.

Als Isolationsmaterial zur Herstellung der inselförmigen Isolatorschichten 12 und 13 wird bspw. ein geeignetes Prepregmaterial, z. B. Epoxydharz verwendet.

Nach dem vervollständigten Schichtenaufbau des Schaltungsträgers 1 wird nicht nur die Durchgangsbohrung 14 für die Durchkontaktierung 10 sondern auch die Sachlochbohrung 15 für die Durchkontaktierung 11 erzeugt und anschließend die Durchkontaktierungs-Hülse 16 bzw. 17 in diese Durchgangsbohrung 14 bzw. Sachlochbohrung 15 eingeführt.

Während der Herstellung des Schichtenaufbaus des Schaltungsträgers 1 wird die Metallschicht 4 im Bereich der Durchkontaktierung 10 durch Erzeugung eines die Durchkontaktierungs-Hülse 16 umgebenden kreisförmigen Ausschnittes 18 strukturiert, so dass ein ausreichender Isolationsabstandes zwischen dieser Metallschicht 4 und der Durchkontaktierungs-Hülse 16 entsteht.

Mit einer entsprechenden Strukturierung werden auch die Leiterbahnebenen 19 und 20 der Mehrlagen-Leiterplatte 5 versehen, so dass auch dort die Durchkontaktierungs-Hülse 16 umgebende kreisförmige Ausschnitte 21 und 22 entstehen.

Im Bereich der Durchkontaktierung 11 zur Metallebene 4 weisen diese Leiterbahnebenen 19 und 20 keine solchen Ausschnitte auf, so dass diese mit der Durchkontaktierungs-Hülse 17 einen elektrischen Kontakt bilden.

Wird diese Mehrebenen-Leiterplatte 5 neben LED's auch zusätzlich mit einem integrierten Schaltkreis (IC) als Steuerschaltung für diese LED's bestückt, lässt sich mittels diesen zusätzlichen Leitbahnebenen 19 und 20 eine platzsparende Verdrahtung erzielen. Die Schichtdicken der Leitbahnebenen 6a, 19 und 20 liegen bei ca. 15pm bis 20pm. Die als Stromschienen dienenden Metallschichten 3 und 4 weisen dagegen zwangsläufig eine größere Dicke auf, die zwischen 80pm und 250pm liegt. Zusätzlich können auch diese Metallschichten 3 und 4 strukturiert werden.

### Bezugszeichenliste

- 1: Schaltungsträger
- 2: Kernsubstrat
- 3: Metallschicht
- 4: Metallschicht
- 5: Außenschicht, Leiterplatte, Mehrlagen-Leiterplatte
- 6: Leitbahnen
- 6a: Kupferschicht
- 7: Metallkern
- 8: Isolierschicht, Prepreg-Schicht
- 9: Isolierschicht, Prepreg-Schicht

- 10: Durchkontaktierungen zur Metallschicht 3
- 11: Durchkontaktierung zur Metallschicht 4
- 12: inselförmige Isolatorschicht
- 12a: Bohrung zur Aufnahme der inselförmigen Isolatorschicht 12
- 13: inselförmige Isolatorschicht
- 13a: Bohrung zur Aufnahme der inselförmigen Isolatorschicht 13
- 14: Durchgangsbohrung
- 15: Sachlochbohrung
- 16: Hülse, Durchkontaktierungs-Hülse
- 17: Hülse, Durchkontaktierungs-Hülse
- 18: Ausschnitt in der Metallschicht 4
- 19: Leitbahnebene der Mehrlagen-Leiterplatte 5
- 20: Leitbahnebene der Mehrlagen-Leiterplatte 5

- 21: Ausschnitt der Leitbahnebene 19
- 22: Ausschnitt der Leitbahnebene 20
- 23: Außenlage der Mehrlagen-Leiterplatte 5
- 24: Innenlage der Mehrlagen-Leiterplatte 5
- 25: Außenlage der Mehrlagen-Leiterplatte 5

## Patentansprüche

1. LED-Schaltungsträger (1) mit wenigstens zwei übereinander angeordneten, durch ein isolierendes Kernsubstrat (2) getrennten Metallschichten (3,4) sowie mit wenigstens auf einer der Metallschichten (3, 4) angeordneten Außenschicht (5) mit Leitbahnen (6) zur Bestückung von LEDs, die mit den Metallschichten (3,4) verbindbar sind, wobei die Leitbahnen (6) auf der Außenschicht (5) über Durchkontaktierungen (10, 11) mit den Metallschichten (3, 4) elektrisch verbunden sind, und eine Durchkontaktierung (11) zur auf der Außenschicht (5) zugewandten Seite des Kernsubstrats (2) liegenden Metallschicht (4) als Sacklochbohrung (15) ausgebildet ist, die im Bereich dieser Metallschicht (4) endet,
**dadurch·gekennzeichnet,** dass
das Kernsubstrat (2) mit einem Metallkern (7) ausgebildet ist, welcher auf den Außenseiten, die den Metallschichten (3,4) benachbart sind, eine Isolierschicht (8, 9) aufweist, und
wobei zur elektrischen Isolation der Durchkontaktierungen (10, 11) gegenüber dem Metallkern (7) die Durchkontaktierungen (10, 11) mittels je einer inselförmigen Isolatorschicht (12, 13) des Metallkerns (7) isoliert sind,
wobei ein Sacklochgrund der Sacklochbohrung (15) bis in den Bereich des Metallkerns (7) reicht, und dass eine der inselförmigen Isolatorschichten (13) den Sacklochgrund der Sacklochbohrung (15) umschließt.

2. LED-Schaltungsträger (1) nach Anspruch 1,
**dadurch gekennzeichnet, dass**
die Durchkontaktierung (10) zur auf der Außenschicht (5) abgewandten Seite des Kernsubstrats (2) liegenden Metallschicht (3) als Durchgangsbohrung (14) ausgebildet ist, die eine elektrisch leitfähige Hülse (16) aufnimmt.

3. LED-Schaltungsträger (1) nach Anspruch 1 oder 2,
**dadurch gekennzeichnet, dass** eine der inselförmigen Isolatorschichten (12) die mit der Metallschicht (3) elektrisch verbundene Durchkontaktierung (10) ringförmig umschließt.

4. LED-Schaltungsträger (1) nach einem der vorhergehenden Ansprüche,
**dadurch gekennzeichnet, dass**
die der Außenschicht (5) zugewandte Metallschicht (4) im Bereich der mit der Metallschicht (3) elektrisch verbundenen Durchkontaktierung (10) zur Bildung eines Isolationsabstandes einen Ausschnitt (18) aufweist.

5. LED-Schaltungsträger (1) nach einem der vorhergehenden Ansprüche,
**dadurch gekennzeichnet, dass**
die Außenschicht (5) als Leiterplatte (5) mit wenigstens einer weiteren Leitbahnebene (19, 20) ausgebildet ist.

6. LED-Schaltungsträger (1) nach Anspruch 5,
**dadurch gekennzeichnet, dass**
im Bereich der Durchkontaktierungen (10, 11) die weitere Leitbahnebene (19, 20) zur Bildung eines Isolationsabstandes einen Ausschnitt (21, 22) aufweist.

## Claims

1. LED circuit carrier (1) comprising at least two metal layers (3, 4) which are arranged one above the other and are separated by an insulating core substrate (2), and also comprising an outer layer (5) which is arranged on at least one of the metal layers (3, 4) and has conductor tracks (6) to be populated with LEDs which can be connected to the metal layers (3, 4), wherein the conductor tracks (6) on the outer layer (5) are electrically connected by means of through connections (10, 11) to the metal layers (3, 4), and a through connection (11) to the metal layer (4) lying on the side of the core substrate (2) facing the outer layer (5) is formed as a blind bore (15) which ends in the region of this metal layer (4), **characterised in that** the core substrate (2) is formed with a metal core (7) which has an insulating layer (8, 9) on the outer sides which are adjacent to the metal layers (3, 4), and wherein for electrical insulation of the through connections (10, 11) relative to the metal core (7) the through connections (10, 11) are each insulated by means of an island-like insulator layer (12, 13) of the metal core (7), wherein a blind base of the blind bore (15) extends into the region of the metal core (7), and one of the island-like insulator layers (13) surrounds the blind base of the blind bore (15).

2. LED circuit carrier (1) according to claim 1, **characterised in that** the through connection to the metal layer (3) lying on the side of the core substrate (1) facing away from the outer layer (5) is formed as a through bore (14) which receives an electrically conductive sleeve (16).

3. LED circuit carrier (1) according to claim 1 or 2, **characterised in that** one of the island-like isolator layers (12) like a ring surrounds the through connection (10) which is electrically connected to the metal layer (3).

4. LED-circuit carrier (1) according to one of the preceding claims, **characterised in that** the metal layer (4) facing the outer layer (5) in the region of the through connection (10) electrically connected to the metal layer (3) has a cutout (18) in order to form an insulation distance.

5. LED circuit carrier (1) according to one of the preceding claims, **characterised in that** the outer layer (5) is formed as a circuit board (5) having at least one further conductor track level (19, 20).

6. LED circuit carrier (1) according to claim 5, **characterised in that** in the region of the through connections (10, 11) the further conductor track level (19, 20) has a cutout (21, 22) to form an insulation distance.

## Revendications

1. Support de circuit à LED (1) comportant au moins deux couches métalliques (3, 4) situées l'une au dessus de l'autre et séparées par un substrat de noyau isolant (2) ainsi qu'une couche externe (5) située au moins sur l'une des couches métalliques (3, 4) et équipée de lignes conductrices (6) permettant le montage de LED, qui peuvent être reliées aux couches métalliques (3, 4), les lignes conductrices (6) situées sur la couche externe (5) étant reliées électriquement aux couches métalliques (3, 4) par l'intermédiaire de contacts traversants (10, 11), et un contact traversant (11) pour la couche métallique (5) située sur le côté du substrat de noyau (2) tourné vers la couche externe (5) étant réalisé sous la forme d'un perçage borgne (15) se terminant dans la zone de cette couche métallique,
**caractérisé en ce que**
le substrat de noyau (2) est réalisé avec un noyau métallique (7) qui comporte une couche isolante (8, 9) sur les côtés externes qui sont situés au voisinage des couches métalliques (3, 4), et, pour permettre l'isolation électrique des contacts traversants (10, 11) par rapport au noyau métallique (7) ces contacts traversants (10, 11) sont respectivement isolés par une couche d'isolation (12, 13) en forme d'ilot du noyau métallique (7),
la base du trou borgne (15) atteignant la zone du noyau métallique (7) et l'une des couches d'isolation en forme d'ilot (13) entourant la base du trou borgne (15).

2. Support de circuit à LED (1) conforme à la revendication 1,
**caractérisé en ce que**
le contact traversant (10) pour la couche métallique (3) située sur le côté du substrat de noyau (2) opposé à la couche externe (5) est réalisé sous la forme d'un perçage traversant (14) qui reçoit une douille électriquement conductrice (16).

3. Support de circuit à LED (1) conforme à la revendication 1 ou 2,
**caractérisé en ce que**
l'une des couches d'isolation en forme d'ilot (12) entoure annulairement le contact traversant (10) relié électriquement à la couche métallique (3).

4. Support de circuit à LED (1) conforme à l'une des revendications précédentes,
**caractérisé en ce que**
la couche métallique (4) tournée vers la couche externe (5) comporte dans la zone du contact traversant (10) relié électriquement à la couche métallique (3) une découpe (18) permettant de former un intervalle d'isolation.

5. Support de circuit à LED (1) conforme à l'unes des revendications précédentes,
**caractérisé en ce que**
la couche externe (5) est réalisée sous la forme d'une plaque conductrice (5) ayant au moins un autre plan de lignes conductrices (19, 20).

6. Support de circuit à LED (1) conforme à la revendication 5,
**caractérisé en ce que**
dans la zone des contacts traversants (10, 11) l'autre plan de lignes conductrices (19, 20) comporte une découpe (21, 22) pour former un intervalle d'isolation.
